# EUROPEAN PATENT APPLICATION

(11) **EP 4 425 549 A1**
(43) Date of publication of application: **04.09.2024**
(21) Application number: 24158561.1
(22) Date of filing: 20.02.2024
(51) Int. Cl.: H01L 25/075, H01L 25/16, H01L 33/44, H01L 33/62

(54) **DISPLAY DEVICE**

(30) Priority: 28.02.2023 KR 20230026957
(71) Applicant: LG Display Co., Ltd., Seoul 07336 (KR)
(72) Inventor: PARK, Sangmin, 10845 Paju-si, Gyeonggi-do (KR); PARK, ChangBae, 10845 Paju-si, Gyeonggi-do (KR); YEO, Gwangmin, 10845 Paju-si, Gyeonggi-do (KR)
(74) Representative: Viering, Jentschura & Partner mbB Patent- und Rechtsanwälte

(57) **Abstract**

According to an aspect of the present disclosure, a display device (100) includes a substrate (110) including an active area (AA) in which the plurality of sub pixels (SP) is disposed and a non-active area (NA) which encloses the active area (AA); a plurality of transistors (DT) disposed in each of the plurality of sub pixels (SP); a first passivation layer (115a) which covers the plurality of transistors (DT) and is formed of an inorganic material; a first planarization layer (116a) which covers the first passivation layer (115a); a second passivation layer (115b) which covers the first planarization layer (116a) and is formed of an inorganic material; an adhesive layer (AD) disposed on the second passivation layer (115b); a plurality of light emitting diodes (130) disposed on the adhesive layer (AD); a first protection layer (117) disposed on the adhesive layer (AD) and the plurality of light emitting diodes (130); and a third passivation layer (115c) which covers the first protection layer (117) and is formed of an inorganic material.

## Description

### BACKGROUND

### Field

The present disclosure relates to a display device, and more particularly, to a display device using a light emitting diode (LED).

### Description of the Related Art

As display devices which are used for a monitor of a computer, a television, a cellular phone, or the like, there are an organic light emitting display (OLED) device which is a self-emitting device, a liquid crystal display (LCD) device which requires a separate light source, and the like.

An applicable range of the display device is diversified to personal digital assistants as well as monitors of computers and televisions and a display device with a large display area and a reduced volume and weight is being studied.

Further, recently, a display device including a light emitting diode (LED) is attracting attention as a next generation display device. Since the LED is formed of an inorganic material, rather than an organic material, reliability is excellent so that a lifespan thereof is longer than that of the liquid crystal display device or the organic light emitting display device. Further, the LED has a fast lighting speed, excellent luminous efficiency, and a strong impact resistance so that a stability is excellent and an image having a high luminance can be displayed.

### SUMMARY

An object to be achieved by the present disclosure is to provide a display device which is capable of minimizing moisture permeation from an organic layer above a light emitting diode.

Another obj ect to be achieved by the present disclosure is to provide a display device which is capable of minimizing a defect of a light emitting diode due to moisture permeation.

Objects of the present disclosure are not limited to the above-mentioned obj ects, and other objects, which are not mentioned above, can be clearly understood by those skilled in the art from the following descriptions. According to an aspect of the present disclosure, a display device according to claim 1 is provided. Further embodiments are described in the dependent claims.

According to an aspect of the present disclosure, a display device includes a substrate including an active area in which the plurality of sub pixels is disposed and a non-active area which encloses the active area; a plurality of transistors disposed in each of the plurality of sub pixels; a first passivation layer which covers the plurality of transistors and is formed of an inorganic material; a first planarization layer which covers the first passivation layer; a second passivation layer which covers the first planarization layer and is formed of an inorganic material; an adhesive layer disposed on the second passivation layer; a plurality of light emitting diodes disposed on the adhesive layer; a first protection layer disposed on the adhesive layer and the plurality of light emitting diodes; and a third passivation layer which covers the first protection layer and is formed of an inorganic material.

Other detailed matters of the exemplary embodiments are included in the detailed description and the drawings.

According to the effect of the present disclosure, the moisture permeation from the organic layer above the light emitting diode is minimized to minimize the defect of the light emitting diode.

According to the effect of the present disclosure, the defect of the light emitting diode is minimized to improve a display quality of the display device.

The effects according to the present disclosure are not limited to the contents exemplified above, and more various effects are included in the present specification.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a schematic diagram of a display device according to an exemplary embodiment of the present disclosure;
FIG. 2A is a partial cross-sectional view of a display device according to an exemplary embodiment of the present disclosure;
FIG. 2B is a perspective view of a tiling display device according to an exemplary embodiment of the present disclosure;
FIG. 3A is a plan view of a display panel before grinding of a display device according to an exemplary embodiment of the present disclosure;
FIG. 3B is a plan view of a display panel after grinding of a display device according to an exemplary embodiment of the present disclosure;
FIGS. 4A and 4B are plan views illustrating a pixel area of a display device according to an exemplary embodiment of the present disclosure;
FIG. 5 is a cross-sectional view of a pixel area of a display device according to an exemplary embodiment of the present disclosure;
FIG. 6 is a cross-sectional view taken along A-A' of FIG. 3B; and
FIG. 7 is a cross-sectional view taken along B-B' of FIG. 3B.

### DETAILED DESCRIPTION OF THE EMBODIMENT

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as 'including', 'having', 'consist of used herein are generally intended to allow other components to be added unless the terms are used with the term 'only'. Any references to singular may include plural unless expressly stated otherwise.

Components are interpreted to include an ordinary error range even if not expressly stated.

When the position relation between two parts is described using the terms such as 'on', 'above', 'below', 'next', one or more parts may be positioned between the two parts unless the terms are used with the term 'immediately' or 'directly'.

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, various embodiments of the present disclosure will be described in detail with reference to accompanying drawings.

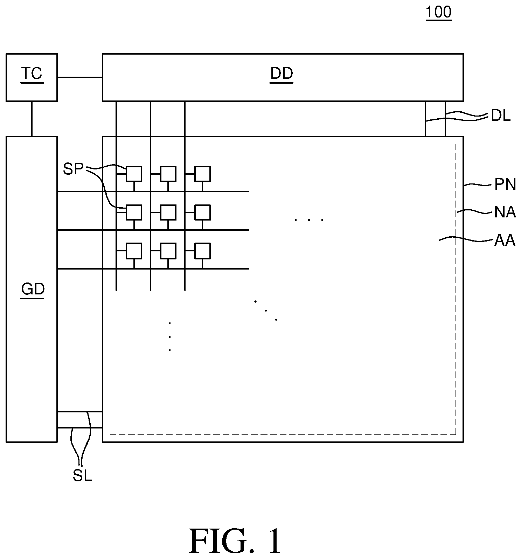

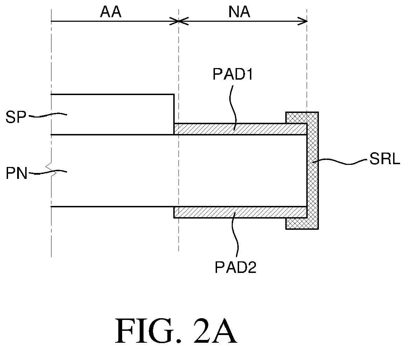

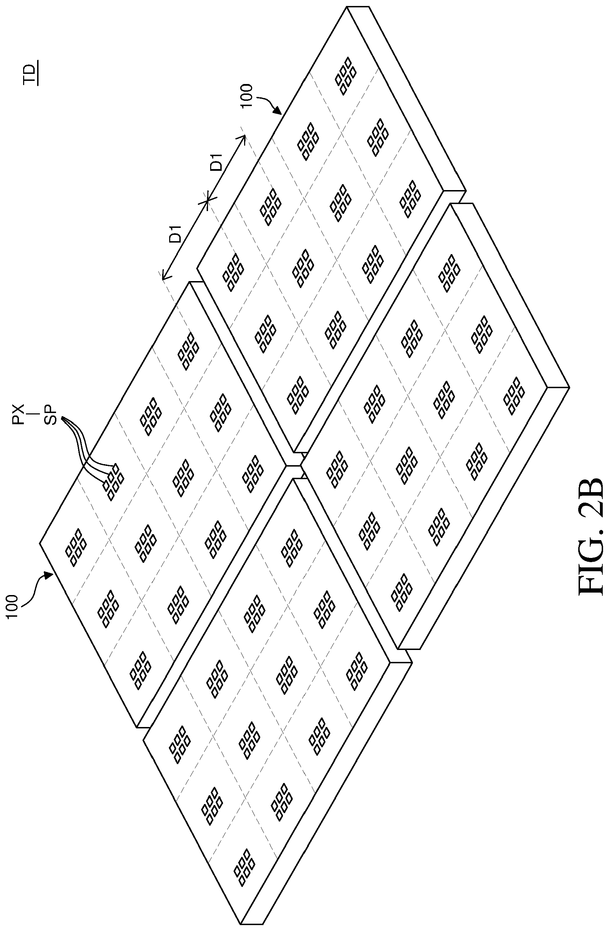

FIG. 1 is a schematic diagram of a display device according to an exemplary embodiment of the present disclosure. FIG. 2A is a partial cross-sectional view of a display device according to an exemplary embodiment of the present disclosure. FIG. 2B is a perspective view of a tiling display device according to an exemplary embodiment of the present disclosure. In FIG. 1, for the convenience of description, among various components of the display device 100, only a display panel PN, a gate driver GD, a data driver DD, and a timing controller TC are illustrated.

Referring to FIG. 1, the display device 100 includes a display panel PN including a plurality of sub pixels SP, a gate driver GD and a data driver DD which supply various signals to the display panel PN, and a timing controller TC which controls the gate driver GD and the data driver DD.

The gate driver GD supplies a plurality of scan signals to a plurality of scan lines SL in accordance with a plurality of gate control signals supplied from the timing controller TC. Even though in FIG. 1, it is illustrated that one gate driver GD is disposed to be spaced apart from one side of the display panel PN, the number of the gate drivers GD and the placement thereof are not limited thereto.

The data driver DD converts image data input from the timing controller TC into a data voltage using a reference gamma voltage in accordance with a plurality of data control signals supplied from the timing controller TC. The data driver DD may supply the converted data voltage to the plurality of data lines DL.

The timing controller TC aligns image data input from the outside to supply the image data to the data driver DD. The timing controller TC may generate a gate control signal and a data control signal using synchronization signals input from the outside, such as a dot clock signal, a data enable signal, and horizontal/vertical synchronization signals. The timing controller TC supplies the generated gate control signal and data control signal to the gate driver GD and the data driver DD, respectively, to control the gate driver GD and the data driver DD.

The display panel PN is a configuration which displays images to the user and includes the plurality of sub pixels SP. In the display panel PN, the plurality of scan lines SL and the plurality of data lines DL intersect each other and the plurality of sub pixels SP is connected to the scan lines SL and the data lines DL, respectively. In addition, even though it is not illustrated in the drawing, each of the plurality of sub pixels SP may be connected to a high potential power line, a low potential power line, a reference line, and the like.

In the display panel PN, an active area AA and the non-active area NA enclosing the active area AA may be defined.

The active area AA is an area in which images are displayed in the display device 100. In the active area AA, a plurality of sub pixels SP which configures a plurality of pixels PX and a circuit for driving the plurality of sub pixels SP may be disposed. The plurality of sub pixels SP is a minimum unit which configures the active area AA and n sub pixels SP may form one pixel. In each of the plurality of sub pixels SP, a light emitting diode, a thin film transistor for driving the light emitting diode, and the like may be disposed. The plurality of light emitting diodes may be defined in different manners depending on the type of the display panel PN. For example, when the display panel PN is an inorganic light emitting display panel, the light emitting diode may be a light emitting diode (LED) or a micro light emitting diode (LED).

In the active area AA, a plurality of wiring lines which transmits various signals to the plurality of sub pixels SP is disposed. For example, the plurality of wiring lines may include a plurality of data lines DL which supplies a data voltage to each of the plurality of sub pixels SP, a plurality of scan lines SL which supplies a scan signal to each of the plurality of sub pixels SP, and the like. The plurality of scan lines SL extends in one direction in the active area AA to be connected to the plurality of sub pixels SP and the plurality of data lines DL extends in a direction different from the one direction in the active area AA to be connected to the plurality of sub pixels SP. In addition, in the active area AA, a low potential power line, a high potential power line, and the like may be further disposed, but are not limited thereto.

The non-active area NA is an area where images are not displayed so that the non-active area NA may be defined as an area extending from the active area AA. In the non-active area NA, a link line which transmits a signal to the sub pixel SP of the active area AA, a pad electrode, a driving IC, such as a gate driver IC or a data driver IC, or the like may be disposed.

In the meantime, the non-active area NA may be located on a rear surface of the display panel PN, that is, a surface on which the sub pixels SP are not disposed or may be omitted, and is not limited as illustrated in the drawing.

In the meantime, a driver, such as a gate driver GD, a data driver DD, and a timing controller TC, may be connected to the display panel PN in various ways. For example, the gate driver GD may be mounted in the non-active area NA in a gate in panel (GIP) manner or mounted between the plurality of sub pixels SP in the active area AA in a gate in active area (GIA) manner. For example, the data driver DD and the timing controller TC are formed in separate flexible film and printed circuit board. The data driver and the timing controller may be electrically connected to the display panel PN by bonding the flexible film and the printed circuit board to the pad electrode formed in the non-active area NA of the display panel PN.

If the gate driver GD is mounted in the GIP manner and the data driver DD and the timing controller TC transmit a signal to the display panel PN through a pad electrode of the non-active area NA, an area of the non-active area NA for disposing the gate driver GD and the pad electrode is necessary more than a predetermined level. Accordingly, a bezel may be increased.

In contrast, when the gate driver GD is mounted in the active area AA in the GIA manner and a side line which connects the signal line on the front surface of the display panel PN to the pad electrode on a rear surface of the display panel PN is formed to bond the flexible film and the printed circuit board onto a rear surface of the display panel PN, the non-active area NA may be minimized on the front surface of the display panel PN. That is, when the gate driver GD, the data driver DD, and the timing controller TC are connected to the display panel PN as described above, a zero bezel with substantially no bezel may be implemented.

Specifically, referring to FIGS. 2A and 2B, in the non-active area NA of the display panel PN, a plurality of pad electrodes PAD1 and PAD2 for transmitting various signals to the plurality of sub pixels SP is disposed. For example, in the non-active area NA on the front surface of the display panel PN, a plurality of first pad electrodes PAD1 which transmits a signal to the plurality of sub pixels SP is disposed. In the non-active area NA on the rear surface of the display panel PN, a plurality of second pad electrodes PAD2 which is electrically connected to a driving component, such as a flexible film and the printed circuit board, is disposed. That is, on the front surface of the display panel PN on which images are displayed, only a pad area of the non-active area NA in which the first pad electrode PAD1 is disposed may be formed at minimum.

In this case, even though it is not illustrated in the drawing, various signal lines connected to the plurality of sub pixels SP, for example, a scan line SL, a data line DL, or the like extend from the active area AA to the non-active area NA to be electrically connected to the first pad electrode PAD1.

The side line SRL is disposed along a side surface of the display panel PN. The side line SRL may electrically connect a first pad electrode PAD1 on the front surface of the display panel PN and a second pad electrode PAD2 on the rear surface of the display panel PN. Therefore, a signal from a driving component on the rear surface of the display panel PN may be transmitted to the plurality of sub pixels SP through the second pad electrode PAD2, the side line SRL, and the first pad electrode PAD1. Accordingly, a signal transmitting path from the front surface of the display panel PN to the side surface and the rear surface is formed to minimize an area of the non-active area NA on the front surface of the display panel PN.

Referring to FIG. 2B, a tiling display device TD having a large screen size may be implemented by connecting a plurality of display devices 100. At this time, as illustrated in FIG. 2A, when the tiling display device TD is implemented using a display device 100 with a minimized bezel, a seam area in which an image between the display devices TD is not displayed is minimized so that a display quality may be improved.

For example, the plurality of sub pixels SP may form one pixel PX and a distance D1 between an outermost pixel PX of one display device 100 and an outermost pixel PX of another display device 100 adjacent to one display device may be implemented to be equal to a distance D1 between pixels PX in one display device 100. Accordingly, a distance D1 between pixels PX between the display devices 100 is constantly configured to minimize the seam area.

However, FIGS. 2A and 2B are illustrative so that the display device according to the exemplary embodiment of the present disclosure may be a general display device with a bezel, but is not limited thereto.

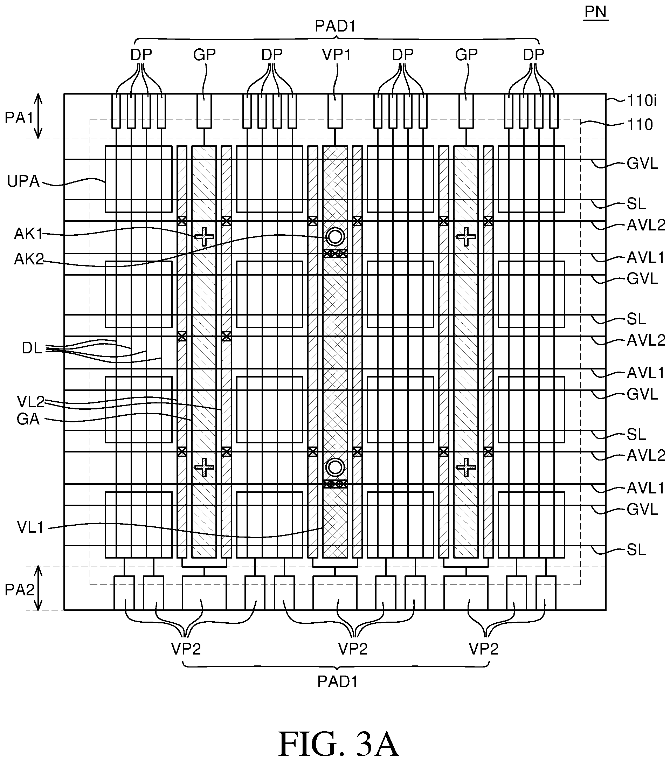

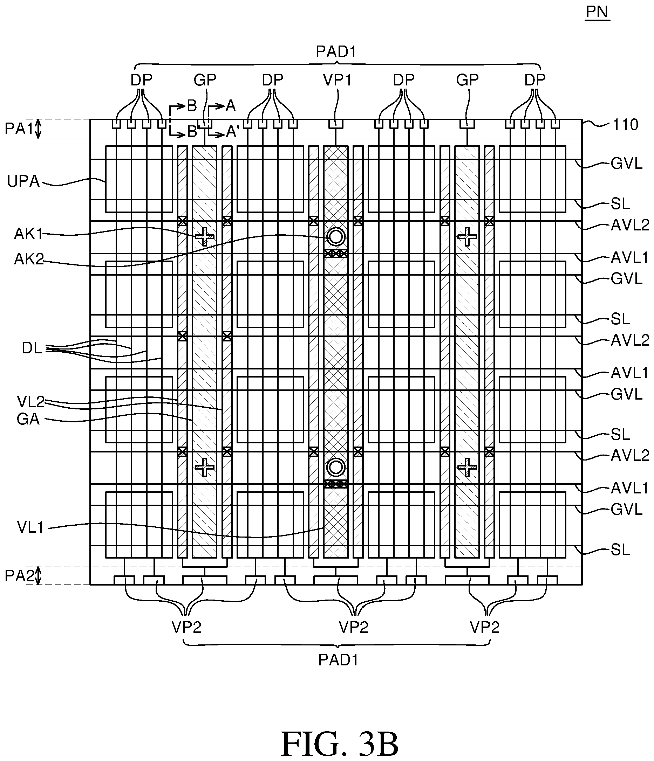

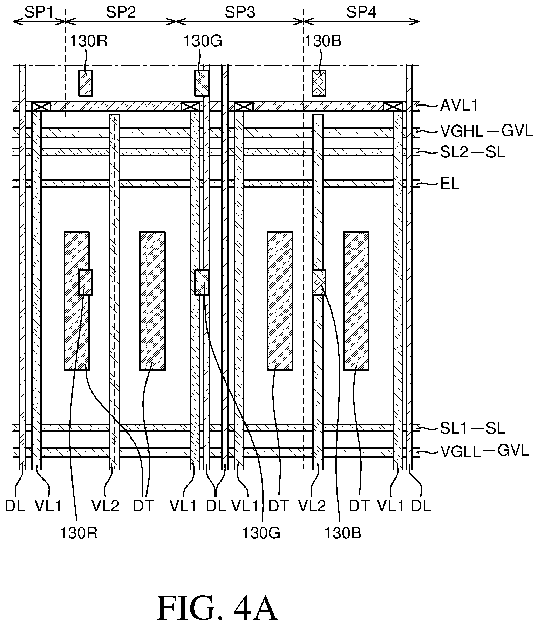

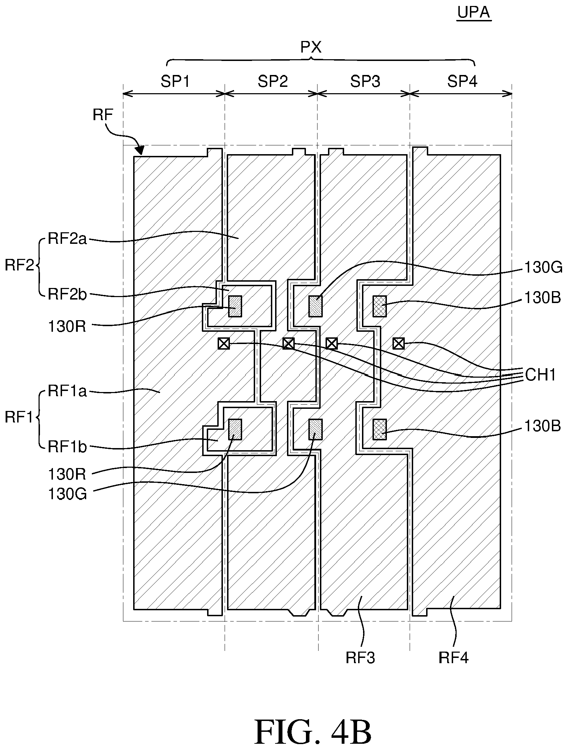

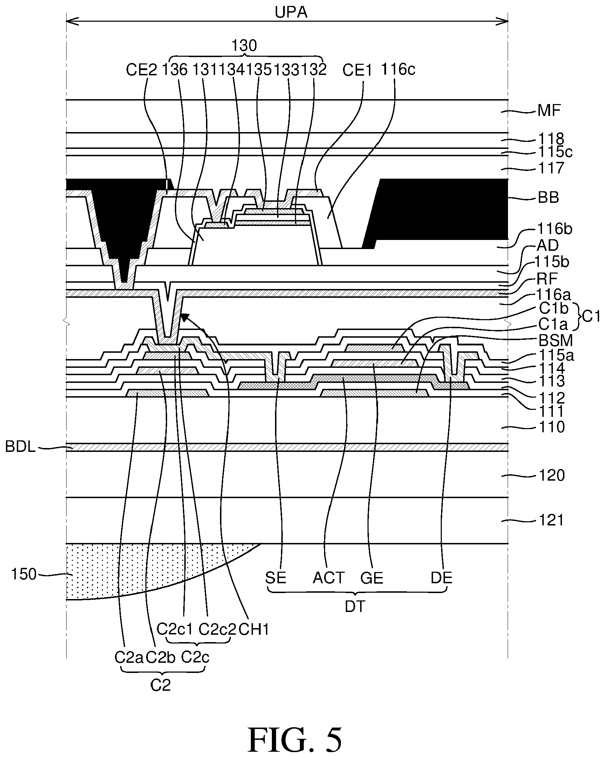

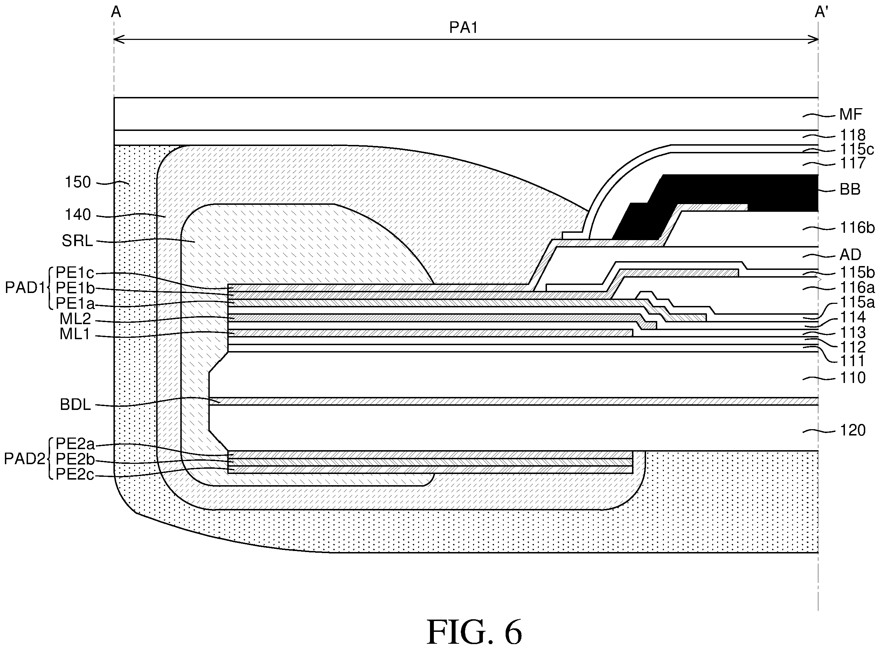

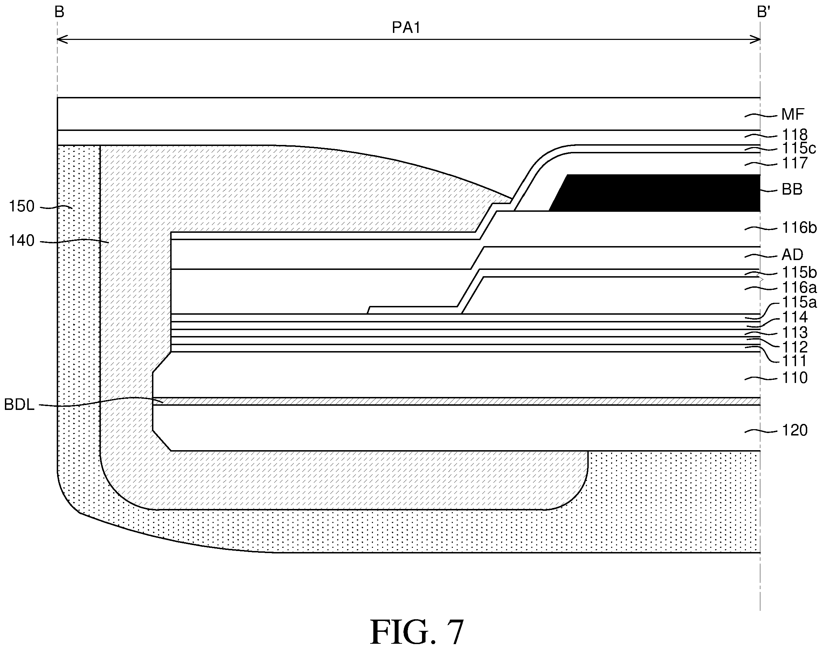

FIG. 3A is a plan view of a display panel before grinding of a display device according to an exemplary embodiment of the present disclosure. FIG. 3B is a plan view of a display panel after grinding of a display device according to an exemplary embodiment of the present disclosure. FIGS. 4A and 4B are plan views illustrating a pixel area of a display device according to an exemplary embodiment of the present disclosure. FIG. 5 is a cross-sectional view of a pixel area of a display device according to an exemplary embodiment of the present disclosure. FIG. 6 is a cross-sectional view taken along A-A' of FIG. 3B. FIG. 7 is a cross-sectional view taken along B-B' of FIG. 3B. For the convenience of description, in FIG. 4A, only the plurality of light emitting diodes 130R, 130G, and 130B, a driving transistor DT of the pixel circuit, and a plurality of wiring lines are illustrated and in FIG. 4B, only a plurality of reflection plates RF and a plurality of light emitting diodes 130R, 130G, and 130B are illustrated. FIGS. 6 and 7 are cross-sectional views for explaining a first pad area PA1 of the display device 100 according to an exemplary embodiment of the present disclosure.

First, referring to FIGS. 3A to 7, the display panel PN includes a first substrate 110. The first substrate 110 is a substrate which supports components disposed above the display device 100 and may be an insulating substrate. A plurality of pixels PX is formed on the first substrate 110 to display images. For example, the first substrate 110 may be formed of glass, resin, or the like. Further, the first substrate 110 may include polymer or plastic. In some exemplary embodiments, the first substrate 110 may be formed of a plastic material having flexibility.

Referring to FIGS. 3A and 3B, in the first substrate 110, a plurality of pixel areas UPA, a plurality of gate driving areas GA, and a plurality of pad areas PA1 and PA2 are disposed. Among them, the plurality of pixel areas UPA and the plurality of gate driving areas GA may be included in the active area AA of the display panel PN.

First, the plurality of pixel areas UPA is areas in which the plurality of pixels PX is disposed. The plurality of pixel areas UPA may be disposed by forming a plurality of rows and a plurality of columns. Each of the plurality of pixels PX disposed in the plurality of pixel areas UPA includes a plurality of sub pixels SP. Each of the plurality of sub pixels SP includes a light emitting diode 130 and a pixel circuit to independently emit light.

The plurality of gate driving areas GA is areas where gate drivers GD are disposed. The gate driver GD may be mounted in the active area AA in a gate in active area (GIA) manner. For example, the gate driving area GA may be formed along a row direction and/or column direction between the plurality of pixel areas UPA. The gate driver GD formed in the gate driving area GA may supply the scan signal to the plurality of scan lines SL.

The gate driver GD disposed in the gate driving area GA may include a circuit for outputting a scan signal. At this time, the gate driver may include a plurality of transistors and/or capacitors. Here, active layers of the plurality of transistors may be formed of a semiconductor material, such as an oxide semiconductor, amorphous silicon, or polysilicon, but are not limited thereto. At this time, the active layers of the plurality of transistors may be formed of the same material or different materials from each other. Further, the active layers of the transistors of the gate driver may be formed of the same material as active layers of various transistors of the pixel circuit or formed of different materials from each other.

The plurality of pad areas PA1 and PA2 is disposed in the non-active area NA at an upper side and a lower side of the display panel PN. The plurality of pad areas PA1 and PA2 is areas in which a plurality of first pad electrodes PAD1 is disposed. The plurality of first pad electrodes PAD1 may transmit various signals to various wiring lines extending in a column direction in the active area AA. For example, the plurality of first pad electrodes PAD1 includes a data pad DP, a gate pad GP, a high potential power pad VP1, and a low potential power pad VP2. The data pad DP transmits a data voltage to the data line DL and the gate pad GP transmits a clock signal, a start signal, a gate low voltage, a gate high voltage, and the like for driving the gate driver GD to the gate driver GD. The high potential power pad VP1 transmits a high potential power voltage to the high potential power line VL1 and the low potential power pad VP2 transmits a low potential power voltage to the low potential power line VL2.

The plurality of pad areas PA1 and PA2 includes a first pad area PA1 located at an upper edge of the display panel PN and a second pad area PA2 located at a lower edge of the display panel PN. In the first pad area PA1 and the second pad area PA2, the plurality of first pad areas PAD1 is disposed to transmit a signal to the plurality of sub pixels SP. At this time, in the first pad area PA1 and the second pad area PA2, different types of first pad electrodes PAD1 may be disposed. For example, in the first pad area PA1, among the plurality of first pad electrodes PAD1, the data pad DP, the gate pad GP, and the high potential power pad VP1 may be disposed and in the second pad area PA2, the low potential power pad VP2 may be disposed.

At this time, the plurality of first pad electrodes PAD1 may be formed to have different sizes, respectively. For example, the plurality of data pads DP which is connected to the plurality of data lines DL one to one may have a smaller width and the high potential power pad VP1, the low potential power pad VP2, and the gate pad GP may have a larger width. However, widths of the data pad DP, the gate pad GP, the high potential power pad VP1, and the low potential power pad VP2 illustrated in FIGS. 3A and 3B are illustrative so that the first pad electrode PAD1 may be configured in various sizes, but is not limited thereto.

In the meantime, in order to reduce the bezel of the display panel PN, an edge of the display panel PN may be cut to be removed. For example, as illustrated in FIG. 3A, the plurality of pixels PX, the plurality of wiring lines, and the plurality of first pad electrodes PAD1 are formed on an initial first substrate 110i and as illustrated in FIG. 3B, an edge part of the initial first substrate 110i is ground to reduce the bezel area. During the grinding process, a part of the initial first substrate 110i is removed to form a first substrate 110 with a smaller size. At this time, parts of the plurality of first pad electrodes PAD1 and wiring lines disposed at the edge of the first substrate 110 may be removed. Accordingly, only a part of the plurality of first pad electrodes PAD1 may remain on the first substrate 110.

Next, the plurality of data lines DL which extends in a column direction from the plurality of first pad electrodes PAD1 is disposed on the first substrate 110 of the display panel PN. The plurality of data lines DL may extend from the plurality of data pads DP of the first pad area PA1 toward the plurality of pixel areas UPA. The plurality of data lines DL may extend in a column direction and may be disposed to overlap the plurality of pixel areas UPA. Therefore, the plurality of data lines DL may transmit the data voltage to the pixel circuit of each of the plurality of sub pixels SP.

The plurality of high potential power lines VL1 extending in the column direction is disposed on the first substrate 110 of the display panel PN. Some of the plurality of high potential power lines VL1 extend from the high potential power pad VP1 of the first pad area PA1 to the plurality of pixel areas UPA to transmit the high potential power voltage to the light emitting diode 130 of each of the plurality of sub pixels SP. The others of the plurality of high potential power lines VL1 may be electrically connected to the other high potential power line VL1 by means of an auxiliary high potential power line AVL1 to be described below. In FIGS. 3A and 3B, for the convenience of description, even though it is illustrated that one high potential power line VL1 and one high potential power pad VP1 are disposed, a plurality of high potential power lines VL1 and high potential power pads VP1 may be disposed.

The plurality of low potential power lines VL2 extending in the column direction is disposed on the first substrate 110 of the display panel PN. At least some of the plurality of low potential power lines VL2 extend from the low potential power pad VP2 of the second pad area PA2 to the plurality of pixel areas UPA to transmit the low potential power voltage to the pixel circuit of each of the plurality of sub pixels SP. The others of the plurality of low potential power lines VL2 may be electrically connected to the other low potential power line VL2 by means of an auxiliary low potential power line AVL2 to be described below.

The plurality of scan lines SL extending in the row direction is disposed on the first substrate 110 of the display panel PN. The plurality of scan lines SL extends in the row direction and may be disposed across the plurality of pixel areas UPA and the plurality of gate driving areas GA. The plurality of scan lines SL may transmit the scan signal from the gate driver GD to the pixel circuits of the plurality of sub pixels SP.

A plurality of auxiliary high potential power lines AVL1 extending in the row direction is disposed on the first substrate 110 of the display panel PN. The plurality of auxiliary high potential power lines AVL1 may be disposed in an area between the plurality of pixel areas UPA. The plurality of auxiliary high potential power lines AVL1 extending in the row direction is electrically connected to the plurality of high potential power lines VL1 extending in the column direction through a contact hole and may form a mesh structure. Therefore, the plurality of auxiliary high potential power lines AVL1 and the plurality of high potential power lines VL1 are configured to form a mesh structure to minimize voltage drop and voltage deviation.

A plurality of auxiliary low potential power lines AVL2 extending in the row direction is disposed on the first substrate 110 of the display panel PN. The plurality of auxiliary low potential power lines AVL2 may be disposed in an area between the plurality of pixel areas UPA. The plurality of auxiliary low potential power lines AVL2 extending in the row direction is electrically connected to the plurality of low potential power lines VL2 extending in the column direction through a contact hole to form a mesh structure. Therefore, the plurality of auxiliary low potential power lines AVL2 and the plurality of low potential power lines VL2 are configured to form a mesh structure to reduce a resistance of the wiring line and minimize voltage deviation.

Referring to FIGS. 3A and 4A, the plurality of gate driving lines extending in the row direction and the column direction is disposed on the first substrate 110 of the display panel PN. Some of the plurality of gate driving lines extend from the gate pad GP of the first pad area PA1 to the gate driving area GA to transmit a signal to the gate driver GD. The others of the plurality of gate driving lines extend in the row direction and may transmit the signal to the gate drivers GD of the plurality of gate driving areas GA. Therefore, various signals are transmitted from the gate driving line to the gate driver GD to drive the gate driver GD.

The plurality of gate driving lines may include wiring lines which transmit a clock signal, a start signal, a gate high voltage, a gate low voltage, and the like to the gate driver GD. Therefore, various signals are transmitted from the gate driving line to the gate driver GD to drive the gate driver GD.

For example, referring to FIG. 4A, the plurality of gate driving lines may include a gate power line GVL which transmits a power voltage to the gate driver GD of the gate driving area GA. The plurality of gate power lines GVL includes a first gate power line VGHL which transmits a gate high voltage to the gate driver GD and a second gate power line VGLL which transmits a gate low voltage to the gate driver GD.

A plurality of alignment keys AK1 and AK2 is disposed in an area between the plurality of pixel areas UPA in the display panel PN. The plurality of alignment keys AK1 and AK2 is used for alignment during the manufacturing process of the display panel PN. The plurality of alignment keys AK1 and AK2 includes a first alignment key AK1 and a second alignment key AK2.

The first alignment key AK1 may be disposed in the gate driving area GA between the plurality of pixel areas UPA. The first alignment key AK1 may be used to inspect an alignment position of the plurality of light emitting diodes 130. For example, the first alignment key AK1 may have a cross shape, but is not limited thereto.

The second alignment key AK2 may be disposed to overlap the high potential power line VL1 of an area between the plurality of pixel areas UPA. In the high potential power line VL1, a hole overlapping the second alignment key AK2 is formed to divide the second alignment key AK2 and the high potential power line VL1. The second alignment key AK2 may be used to align the display panel PN and a donor. The display panel PN and the donor are aligned using the second alignment key AK2 and the plurality of light emitting diodes 130 of the donor may be transferred onto the display panel PN. For example, the second alignment key AK2 may have a circular ring shape, but is not limited thereto.

Hereinafter, the plurality of sub pixels SP of the pixel area UPA will be described in more detail with reference to FIGS. 4A to 5.

Referring to FIGS. 4A and 4B, in one pixel area UPA, a plurality of sub pixels SP which forms one pixel PX is disposed. For example, the plurality of sub pixels SP may include a first sub pixel SP1, a second sub pixel SP2, a third sub pixel SP3, and a fourth sub pixel SP4 which emit different color light. For example, the first sub pixel SP1 and the second sub pixel SP2 may be red sub pixels, the third sub pixel SP3 may be a green sub pixel, and the fourth sub pixel SP4 may be a blue sub pixel, but it is not limited thereto.

Hereinafter, the description will be made by assuming that one pixel PX includes one first sub pixel SP1, one second sub pixel SP2, one third sub pixel SP3, and one fourth sub pixel SP4, that is, two red sub pixels, one green sub pixel, and one blue sub pixel. However, the configuration of the pixel PX is not limited thereto.

Referring to FIG. 4A, as described above, a plurality of wiring lines which supplies various signals to the plurality of sub pixels SP is disposed in the plurality of pixel areas UPA of the first substrate 110. For example, the plurality of data lines DL, the plurality of high potential power lines VL1, and the plurality of low potential power lines VL2 extending in the column direction may be disposed on the first substrate 110. For example, the plurality of emission control signal lines, the plurality of auxiliary high potential power lines AVL1, the plurality of auxiliary low potential power lines AVL2, the plurality of first scan lines SL1, and the plurality of second scan lines SL2 extending in the row direction may be disposed on the first substrate 110. The high potential power line VL1 extending in the column direction may be electrically connected to the auxiliary high potential power line AVL1 extending in the row direction through a contact hole. At this time, the emission control signal line transmits an emission control signal to the pixel circuits of the plurality of sub pixels SP to control an emission timing of each of the plurality of sub pixels SP.

Some gate power lines GVL which transmit signals to each of the plurality of gate drivers GD disposed to be spaced apart from each other with the pixel area UPA therebetween may be disposed across the pixel area UPA while extending to the row direction. For example, a first gate power line VGHL which supplies a gate high voltage to the gate driver GD and a second gate power line VGLL which supplies a gate low voltage may be disposed across the pixel area UPA.

In the meantime, even though it is illustrated that the plurality of scan lines SL includes a first scan line SL1 and a second scan line SL2, the configuration of the plurality of scan lines SL may vary depending on the pixel circuit configuration of the sub pixel SP, but is not limited thereto.

The pixel circuit for driving the light emitting diode 130 is disposed in each of the plurality of sub pixels SP on the first substrate 110. The pixel circuit may include a plurality of thin film transistors and a plurality of capacitors. In FIGS. 4A and 5, for the convenience of description, only a driving transistor DT, a first capacitor C1, and a second capacitor C2, among configurations of the pixel circuit are illustrated. However, the pixel circuit may further include a switching transistor, a sensing transistor, an emission control transistor, and the like, but is not limited thereto.

First, a light shielding layer BSM is disposed on the first substrate 110. The light shielding layer BSM blocks light which is incident to an active layer of the plurality of transistors to minimize a leakage current. For example, the light shielding layer BSM is disposed below the active layer ACT of the driving transistor DT to block light incident onto the active layer ACT. If light is irradiated onto the active layer ACT, a leakage current is generated, which deteriorates the reliability of the transistor. Accordingly, the light shielding layer BSM which blocks the light is disposed on the first substrate 110 to improve the reliability of the driving transistor DT. The light shielding layer BSM may be configured by an opaque conductive material such as copper (Cu), aluminum (Al), molybdenum (Mo), nickel (Ni), titanium (Ti), chrome (Cr), or an alloy thereof, but is not limited thereto.

A buffer layer 111 is disposed on the light shielding layer BSM. The buffer layer 111 may reduce permeation of moisture or impurities through the first substrate 110. For example, the buffer layer 111 may be configured by a single layer or a double layer of silicon oxide SiOx or silicon nitride SiNx, but is not limited thereto. However, the buffer layer 111 may be omitted depending on a type of the first substrate 110 or a type of the thin film transistor, but is not limited thereto.

In the meantime, even though it is not illustrated in FIG. 5, an additional buffer layer may be disposed between the first substrate 110 and the light shielding layer BSM. The additional buffer layer may be configured by a single layer or a double layer of silicon oxide SiOx or silicon nitride SiNx to reduce permeation of moisture or impurities through the first substrate 110, like the buffer layer 111 described above.

A driving transistor DT including an active layer ACT, a gate electrode GE, a source electrode SE, and a drain electrode DE is disposed on the buffer layer 111.

First, the active layer ACT of the driving transistor DT is disposed on the buffer layer 111. The active layer ACT may be formed of a semiconductor material such as an oxide semiconductor, amorphous silicon, or polysilicon, but is not limited thereto. Further, even though it is not illustrated in the drawings, other transistors, such as a switching transistor, a sensing transistor, and an emission control transistor, other than the driving transistor DT, may be further disposed. The active layers of the transistors may be also formed of a semiconductor material, such as an oxide semiconductor, amorphous silicon, or polysilicon, but are not limited thereto. The active layer of the transistor included in the pixel circuit, such as the driving transistor DT, the switching transistor, the sensing transistor, and the emission control transistor, may be formed of the same material, or formed of different materials.

Agate insulating layer 112 is disposed on the active layer ACT. The gate insulating layer 112 is an insulating layer which electrically insulates the active layer ACT from the gate electrode GE and may be configured by a single layer or a double layer of silicon oxide SiOx or silicon nitride SiNx, but is not limited thereto.

The gate electrode GE is disposed on the gate insulating layer 112. The gate electrode GE may be configured by a conductive material, such as copper (Cu), aluminum (Al), molybdenum (Mo), nickel (Ni), titanium (Ti), chrome (Cr), or an alloy thereof, but is not limited thereto.

A first interlayer insulating layer 113 and a second interlayer insulating layer 114 are disposed on the gate electrode GE. In the first interlayer insulating layer 113 and the second interlayer insulating layer 114, contact holes through which the source electrode SE and the drain electrode DE are connected to the active layer are formed. The first interlayer insulating layer 113 and the second interlayer insulating layer 114 are insulating layers which protect components therebelow and may be configured by single layers or double layers of silicon oxide SiOx or silicon nitride SiNx, but are not limited thereto.

The source electrode SE and the drain electrode DE which are electrically connected to the active layer ACT are disposed on the second interlayer insulating layer 114. The source electrode SE is connected to the second capacitor C2 and the first electrode 134 of the light emitting diode 130 and the drain electrode DE is connected to the other configuration of the pixel circuit. The source electrode SE and the drain electrode DE may be configured by a conductive material, such as copper (Cu), aluminum (Al), molybdenum (Mo), nickel (Ni), titanium (Ti), chrome (Cr), or an alloy thereof, but are not limited thereto.

Next, the first capacitor C1 is disposed on the gate insulating layer 112. The first capacitor C1 includes a 1-1-th capacitor electrode C1a and a 1-2-th capacitor electrode C1b.

First, the 1-1-th capacitor electrode C1a is disposed on the gate insulating layer 112. The 1-1-th capacitor electrode C1a may be integrally formed with the gate electrode GE of the driving transistor DT.

The 1-2-th capacitor electrode C1b is disposed on the first interlayer insulating layer 113. The 1-2-th capacitor electrode C1b is disposed to overlap the 1-1-th capacitor electrode C1a with the first interlayer insulating layer 113 therebetween.

Therefore, the first capacitor C1 is connected to the gate electrode GE of the driving transistor DT to maintain a voltage of the gate electrode GE of the driving transistor DT for a predetermined period.

Next, the second capacitor C2 is disposed on the first substrate 110. The second capacitor C2 includes a 2-1-th capacitor electrode C2a, a 2-2-th capacitor electrode C2b, and a 2-3-th capacitor electrode C2c. The second capacitor C2 includes the 2-1-th capacitor electrode C2a which is a lower capacitor electrode, the 2-2-th capacitor electrode C2b which is an intermediate capacitor electrode, and the 2-3-th capacitor electrode C2c which is an upper capacitor electrode.

The 2-1-th capacitor electrode C2a is disposed on the first substrate 110. The 2-1-th capacitor electrode C2a is disposed on the same layer as the light shielding layer BSM and may be formed of the same material.

The 2-2-th capacitor electrode C2b is disposed on the buffer layer 111 and the gate insulating layer 112. The 2-2-th capacitor electrode C2b is disposed on the same layer as the gate electrode GE and may be formed of the same material.

The 2-3-th capacitor electrode C2c is disposed on the first interlayer insulating layer 113. The 2-3-th capacitor electrode C2c may be configured by a first layer and a second layer. The first layer C2c1 of the 2-3-th capacitor electrode C2c may be formed on the same layer as the 1-2-th capacitor electrode C1b with the same material. The first layer C2c1 may be disposed to overlap the 2-1-th capacitor electrode C2a and the 2-2-th capacitor electrode C2b with the first interlayer insulating layer 113 therebetween.

The second layer C2c2 of the 2-3-th capacitor electrode C2c is disposed on the second interlayer insulating layer 114. The second layer C2c2 is a part extending from the source electrode SE of the driving transistor DT and may be connected to the first layer C2c1 through the contact hole of the second interlayer insulating layer 114.

Accordingly, the second capacitor C2 is electrically connected between the source electrode SE of the driving transistor DT and the light emitting diode 130 to increase capacitance inherent in the light emitting diode 130 and allow the light emitting diode 130 to emit light with a higher luminance.

A first passivation layer 115a is disposed on the driving transistor DT, the first capacitor C1, and the second capacitor C2. The first passivation layer 115a is an insulating layer for protecting a configuration below the first passivation layer 115a. The first passivation layer 115a may be disposed on the entire first substrate 110. For example, the first passivation layer 115a may cover the plurality of driving transistors DT to protect the driving transistors DT.

The first passivation layer 115a may be formed of an inorganic material, for example, may be formed of silicon oxide SiOx and silicon nitride SiNx, but is not limited thereto.

A first planarization layer 116a is disposed on the first passivation layer 115a. The first planarization layer 116a may be disposed to cover the first passivation layer 115a. The first planarization layer 116a may planarize an upper portion of the pixel circuit including the driving transistor DT. The first planarization layer 116a may be configured by a single layer or a double layer, and for example, configured by benzocyclobutene or an acrylic organic material, but is not limited thereto.

Referring to FIGS. 4B and 5 together, a plurality of reflection plates RF is disposed on the first planarization layer 116a. The reflection plates RF are disposed to overlap the plurality of light emitting diodes 130. The reflection plate RF is a configuration which reflects light emitted from the plurality of light emitting diodes 130 above the first substrate 110 and may be formed with a shape corresponding to each of the plurality of sub pixels SP. One reflection plate RF may be disposed to cover the most area of one sub pixel SP.

The reflection plate RF reflects the light emitted from the light emitting diode 130 and may be also used as an electrode which electrically connects the light emitting diode 130 and the pixel circuit. Therefore, the reflection plate RF may include various conductive layers in consideration of a light reflection efficiency and a resistance. For example, the reflection plate RF may use an opaque conductive layer such as silver (Ag), aluminum (Al), molybdenum (Mo), titanium (Ti), or an alloy thereof and a transparent conductive layer such as indium tin oxide, but the structure of the reflection plate RF is not limited thereto.

The reflection plate RF includes a first reflection plate RF1 corresponding to the first sub pixel SP1, a second reflection plate RF2 corresponding to the second sub pixel SP2, a third reflection plate RF3 corresponding to the third sub pixel SP3, and a fourth reflection plate RF4 corresponding to the fourth sub pixel SP4.

The first reflection plate RF1 includes a 1-1-th reflection plate RF1a overlapping most of the first sub pixel SP1 and a 1-2-th reflection plate RF1b overlapping the red light emitting diode 130R of the first sub pixel SP1. The 1-1-th reflection plate RF1a may reflect light emitted from the red light emitting diode 130R above the red light emitting diode 130R. The 1-1-th reflection plate RF1a may be electrically connected to the source electrode SE of the driving transistor DT and the second capacitor C2 through a first contact hole CH1 of the first planarization layer 116a and the first passivation layer 115a. Therefore, the 1-1-th reflection plate RF1a may electrically connect the driving transistor DT and the first electrode 134 of the red light emitting diode 130R. The 1-2-th reflection plate RF1b may reflect light emitted from the red light emitting diode 130R above the red light emitting diode 130R. The 1-2-th reflection plate RF1b may serve as an electrode which electrically connects the second electrode 135 of the red light emitting diode 130R and the high potential power line VL1.

The second reflection plate RF2 includes a 2-1-th reflection plate RF2a overlapping most of the second sub pixel SP2 and a 2-2-th reflection plate RF2b overlapping the red light emitting diode 130R of the second sub pixel SP2. The 2-1-th reflection plate RF2a may reflect light emitted from the red light emitting diode 130R above the red light emitting diode 130R. The 2-1-th reflection plate RF2a is electrically connected to the source electrode SE of the driving transistor DT and the second capacitor C2 through the first contact hole CH1 to transmit a driving current from the driving transistor DT to the first electrode 134 of the red light emitting diode 130R. The 2-2-th reflection plate RF2b may be used as an electrode which reflects the light emitted from the red light emitting diode 130R above the red light emitting diode 130R and electrically connects the second electrode 135 of the red light emitting diode 130R to the high potential power line VL1.

The third reflection plate RF3 may be formed as one third reflection plate RF3 which overlaps the entire third sub pixel SP3. The third reflection plate RF3 may reflect light emitted from the green light emitting diode 130G of the third sub pixel SP3 above the green light emitting diode 130G. The third reflection plate RF3 is electrically connected to the source electrode SE of the driving transistor DT and the second capacitor C2 through the first contact hole CH1 to transmit a driving current from the driving transistor DT to the first electrode 134 of the green light emitting diode 130G.

The fourth reflection plate RF4 may be formed as one fourth reflection plate RF4 which overlaps the entire fourth sub pixel SP4. The fourth reflection plate RF4 may reflect light emitted from the blue light emitting diode 130B of the fourth sub pixel SP4 above the blue light emitting diode 130B. The fourth reflection plate RF4 is electrically connected to the source electrode SE of the driving transistor DT and the second capacitor C2 through the first contact hole CH1 to transmit a driving current from the driving transistor DT to the first electrode 134 of the blue light emitting diode 130B.

In the meantime, even though it has been described that the first sub pixel SP1 and the second sub pixel SP2 are formed with two reflection plates RF and the third sub pixel SP3 and the fourth sub pixel SP4 are formed with one reflection plate RF, the reflection plate RF may be designed in various manners. For example, only one reflection plate RF may be disposed in all the plurality of sub pixels SP, like the third sub pixel SP3 and the fourth sub pixel SP4 or a plurality of reflection plates RF may be disposed in all the sub pixels, like the first sub pixel SP1 and the second sub pixel SP2, but the reflection plate is not limited thereto.

Further, it has been described that the red light emitting diode 130R of each of the first sub pixel SP1 and the second sub pixel SP2 is electrically connected to the high potential power line VL1 through the 1-2-th reflection plate RF1b and the 2-2-th reflection plate RF2b. However, all the red light emitting diode 130R, the green light emitting diode 130G, and the blue light emitting diode 130B may be separately connected to the high potential power line VL1 without the reflection plate RF, but are not limited thereto.

Referring to FIG. 5, the second passivation layer 115b is disposed on the plurality of reflection plates RF. The second passivation layer 115b is an insulating layer for protecting a configuration below the second passivation layer 115b. The second passivation layer 115b may be disposed on the entire first substrate 110. For example, the second passivation layer may be disposed to cover the plurality of reflection plates RF and the first planarization layer 116a.

The second passivation layer 115b may be formed of an inorganic material. For example, the second passivation layer 115b may be configured by a single layer or a double layer of silicon oxide SiOx or silicon nitride SiNx, but is not limited thereto.

An adhesive layer AD is disposed on the second passivation layer 115b. The adhesive layer AD is formed on the entire surface of the first substrate 110 to fix the light emitting diode 130 disposed on the adhesive layer AD. The adhesive layer AD may be formed of a photo curable adhesive material which is cured by light. For example, the adhesive layer AD may be formed of an acrylic material including a photoresist, but is not limited thereto. The adhesive layer AD may be formed on the entire surface of the first substrate 110 excluding a part of the pad areas PA1 and PA2 in which the first pad electrode PAD1 is disposed.

The plurality of light emitting diodes 130 is disposed in each of the plurality of sub pixels SP on the adhesive layer AD. The light emitting diode 130 is an element which emits light by a current and may include a red light emitting diode 130R which emits red light, a green light emitting diode 130G which emits green light, and a blue light emitting diode 130B which emits blue light and implement light with various colors including white by a combination thereof. For example, the light emitting diode 130 may be a light emitting diode (LED) or a micro LED, but is not limited thereto.

One red light emitting diode 130R is disposed in each of the first sub pixel SP1 and the second sub pixel SP2, one pair of green light emitting diodes 130G is disposed in the third sub pixel SP3, and one pair of blue light emitting diodes 130B is disposed in the fourth sub pixel SP4. That is, two red light emitting diodes 130R, two green light emitting diodes 130G, and two blue light emitting diodes 130B may be disposed in one pixel PX. At this time, each of the red light emitting diodes 130R is connected to the driving transistor DT of each of the first sub pixel SP1 and the second sub pixel SP2 to be individually driven. In contrast, one pair of green light emitting diodes 130G of the third sub pixel SP3 and one pair of blue light emitting diodes 130B of the fourth sub pixel SP4 are connected to one driving transistor DT in parallel to be driven.

The plurality of light emitting diodes 130 is disposed on the adhesive layer AD. The plurality of light emitting diodes 130 includes a first semiconductor layer 131, an emission layer 132, a second semiconductor layer 133, a first electrode 134, and a second electrode 135.

The first semiconductor layer 131 is disposed on the adhesive layer AD and the second semiconductor layer 133 is disposed on the first semiconductor layer 131. The first semiconductor layer 131 and the second semiconductor layer 133 may be layers formed by doping n-type and p-type impurities into a specific material. For example, the first semiconductor layer 131 and the second semiconductor layer 133 may be layers doped with n-type and p-type impurities into a material such as gallium nitride (GaN), indium aluminum phosphide (InAlP), or gallium arsenide (GaAs). The p-type impurity may be magnesium (Mg), zinc (Zn), beryllium (Be), and the like, and the n-type impurity may be silicon (Si), germanium, tin (Sn), and the like, but are not limited thereto.

The emission layer 132 is disposed between the first semiconductor layer 131 and the second semiconductor layer 133. The emission layer 132 is supplied with holes and electrons from the first semiconductor layer 131 and the second semiconductor layer 133 to emit light. The emission layer 132 may be formed by a single layer or a multi-quantum well (MQW) structure, and for example, may be formed of indium gallium nitride (InGaN), gallium nitride (GaN), or the like, but is not limited thereto.

The first electrode 134 is disposed on the first semiconductor layer 131. The first electrode 134 is an electrode which electrically connects the driving transistor DT and the first semiconductor layer 131. In this case, the first semiconductor layer 131 is a semiconductor layer doped with an n-type impurity and the first electrode 134 may be a cathode. The first electrode 134 may be disposed on a top surface of the first semiconductor layer 131 which is exposed from the emission layer 132 and the second semiconductor layer 133. The first electrode 134 may be configured by a conductive material, for example, a transparent conductive material, such as indium tin oxide (ITO) or indium zinc oxide (IZO) or an opaque conductive material, such as titanium (Ti), gold (Au), silver (Ag), copper (Cu) or an alloy thereof, but is not limited thereto.

The second electrode 135 is disposed on the second semiconductor layer 133. The second electrode 135 may be disposed on the top surface of the second semiconductor layer 133. The second electrode 135 is an electrode which electrically connects the high potential power line and the second semiconductor layer 133. In this case, the second semiconductor layer 133 is a semiconductor layer doped with a p-type impurity and the second electrode 135 may be an anode. The second electrode 135 may be configured by a conductive material, for example, a transparent conductive material, such as indium tin oxide (ITO) or indium zinc oxide (IZO) or an opaque conductive material, such as titanium (Ti), gold (Au), silver (Ag), copper (Cu) or an alloy thereof, but is not limited thereto.

Next, the encapsulation layer 136 which encloses the first semiconductor layer 131, the emission layer 132, the second semiconductor layer 133, the first electrode 134, and the second electrode 135 is disposed. The encapsulation layer 136 is formed of an insulating material to protect the first semiconductor layer 131, the emission layer 132, and the second semiconductor layer 133. In the encapsulation layer 136, a contact hole which exposes the first electrode 134 and the second electrode 135 is formed to electrically connect a first connection electrode CE1 and a second connection electrode CE2 to the first electrode 134 and the second electrode 135.

In the meantime, a part of the side surface of the first semiconductor layer 131 may be exposed from the encapsulation layer 136. The light emitting diode 130 manufactured on the wafer is separated from the wafer to be transferred onto the display panel PN. However, during the process of separating the light emitting diode 130 from the wafer, a part of the encapsulation layer 136 may be torn. For example, a part of the encapsulation layer 136 which is adjacent to a lower edge of the first semiconductor layer 131 of the light emitting diode 130 is torn during the process of separating the light emitting diode 130 from the wafer. Accordingly, a part of a lower side surface of the first semiconductor layer 131 may be exposed to the outside. However, even though the lower portion of the light emitting diode 130 is exposed from the encapsulation layer 136, the first connection electrode CE1 and the second connection electrode CE2 are formed after forming the second planarization layer 116b and the third planarization layer 116c which cover the side surface of the first semiconductor layer 131. Accordingly, a short defect may be reduced.

Next, the second planarization layer 116b and the third planarization layer 116c are disposed on the adhesive layer AD and the light emitting diode 130.

The second planarization layer 116b overlaps a part of side surfaces of the plurality of light emitting diodes 130 to fix and protect the plurality of light emitting diodes 130. The second planarization layer 116b may be formed using a halftone mask. Therefore, the second planarization layer 116b may be formed to have a step.

Specifically, a part of the second planarization layer 116b which is relatively adjacent to the light emitting diode 130 may be formed to have a smaller thickness and a part which is farther from the light emitting diode 130 may be formed to have a larger thickness. Apart of the second planarization layer 116b which is adjacent to the light emitting diode 130 is disposed to enclose the light emitting diode 130 and also may be in contact with a side surface of the light emitting diode 130. Therefore, a torn part of the encapsulation layer 136 which protects a side surface of the first semiconductor layer 131 of the light emitting diode 130 during the process of separating the light emitting diode 130 from the wafer to be transferred onto the display panel PN may be covered by the second planarization layer 116b. By doing this, thereafter, contacts and short defects of the connection electrodes CE1 and CE2 and the first semiconductor layer 131 may be suppressed.

The third planarization layer 116c is formed to cover upper portions of the second planarization layer 116b and the light emitting diode 130 and a contact hole which exposes the first electrode 134 and the second electrode 135 of the light emitting diode 130 may be formed. The first electrode 134 and the second electrode 135 of the light emitting diode 130 are exposed from the third planarization layer 116c and the third planarization layer 116c is partially disposed in an area between the first electrode 134 and the second electrode 135 to reduce a short defect. The second planarization layer 116b and the third planarization layer 116c may be configured by a single layer or a double layer, and for example, may be formed of photoresist or an acrylic organic material, but is not limited thereto.

In the meantime, the third planarization layer 116c may cover only the light emitting diode 130 and an area adjacent to the light emitting diode 130. The third planarization layer 116c is disposed in an area of the sub pixel SP enclosed by the bank BB and may be disposed in an island shape. Therefore, the bank BB may be disposed in a part of the top surface of the second planarization layer 116b and the third planarization layer 116c may be disposed in the other part of the top surface of the second planarization layer 116b.

The first connection electrode CE1 and the second connection electrode CE2 are disposed on the third planarization layer 116c. The first connection electrode CE1 is an electrode which electrically connects the second electrode 135 of the light emitting diode 130 and the high potential power line VL1. The first connection electrode CE1 may be electrically connected to the second electrode 135 of the light emitting diode 130 through a contact hole formed in the third planarization layer 116c.

The second connection electrode CE2 is an electrode which electrically connects the first electrode 134 of the light emitting diode 130 and the driving transistor DT. The second connection electrode CE2 may be connected to the 1-1-th reflection plate RF1a, the 1-2-th reflection plate RF1b, the third reflection plate RF3, and the fourth reflection plate RF4 of each of the plurality of sub pixels SP through contact holes formed in the third planarization layer 116c, the second planarization layer 116b, the adhesive layer AD, and the second passivation layer 115b. At this time, the 1-1-th reflection plate RF1a, the 1-2-th reflection plate RF1b, the third reflection plate RF3, and the fourth reflection plate RF4 are also connected to the source electrode SE of the driving transistor DT so that the source electrode SE of the driving transistor DT and the first electrode 134 of the light emitting diode 130 may be electrically connected to each other.

In the meantime, in the drawing, it is illustrated that the first electrode 134, the second connection electrode CE2, and the reflection plate RF are electrically connected to the source electrode SE of the driving transistor DT. However, the first electrode 134, the second connection electrode CE2, and the reflection plate RF may be connected to the drain electrode DE of the driving transistor DT, but it is not limited thereto.

A bank BB is disposed on the second planarization layer 116b exposed from the first connection electrode CE1 and the second connection electrode CE2, and the third planarization layer 116c. The bank BB may be disposed to be spaced apart from the light emitting diode 130 with a predetermined interval and overlap at least partially the reflection plate RF. For example, the bank BB may cover a part of the second connection electrode CE2 formed in the contact holes of the third planarization layer 116c and the second planarization layer 116b. Further, the bank BB may be disposed on the second planarization layer 116b with a predetermined interval from the light emitting diode 130. In this case, the bank BB and the third planarization layer 116c may be spaced apart from each other on a part of the second planarization layer 116b having a smaller thickness. That is, an end of the bank BB and an end of the third planarization layer 116c may be disposed on a part of the second planarization layer 116b having a smaller thickness formed by a halftone mask process to be spaced apart from each other.

The bank BB may be formed of an opaque material to reduce color mixture between the plurality of sub pixels SP and for example, may be formed of black resin, but is not limited thereto.

In the meantime, a thickness of a part of the bank BB which is formed in the contact holes of the third planarization layer 116c and the second planarization layer 116b to cover a part of the second connection electrode CE2 and a thickness of a part disposed on the second planarization layer 116b may be different from each other. Specifically, when the part of the bank BB covers a part of the second connection electrode CE2 formed in the contact holes of the third planarization layer 116c and the second planarization layer 116b, since the contact hole is formed from the second passivation layer 115b to the third planarization layer 116c, the bank BB may be disposed below the light emitting diode 130, that is, disposed to be lower than the light emitting diode 130. Therefore, the thickness of the part of the bank BB which covers a part of the second connection electrode CE2 formed in the contact holes of the third planarization layer 116c and the second planarization layer 116b may be larger than the thickness of a part of the bank BB disposed on the second planarization layer 116b.

A first protection layer 117 is disposed on the first connection electrode CE1, the second connection electrode CE2, and the bank BB. The first protection layer 117 extends to a part of the non-active area NA from the active area AA. Therefore, an end of the first protection layer 117 is disposed in the non-active area NA. The first protection layer 117 is a layer for protecting components below the first protection layer 117, and may be configured by a single layer or a double layer of translucent epoxy, silicon oxide SiOx or silicon nitride SiNx, but is not limited thereto.

The third passivation layer 115c is disposed on the first protection layer 117. The third passivation layer 115c is a configuration for protecting the first protection layer 117 and is disposed to cover the first protection layer 117. The third passivation layer 115c may be disposed in the active area AA and a part of the non-active area NA extending from the active area AA. At this time, the third passivation layer 115c may be disposed to cover an end of the first protection layer 117 in the non-active area NA.

The third passivation layer 115c may be formed of an inorganic material. For example, the third passivation layer 115c may be configured by a single layer or a double layer of silicon oxide SiOx or silicon nitride SiNx, but is not limited thereto.

Hereinafter, a non-active area NA and a plurality of pad areas PA1 and PA2 of a display device 100 according to an exemplary embodiment of the present disclosure will be described in more detail with reference to FIGS. 6 and 7.

A plurality of first pad electrodes PAD1 is disposed in a first pad area PA1 and a second pad area PA2 of the first substrate 110. Each of the plurality of first pad electrodes PAD1 may be configured by a plurality of conductive layers. For example, each of the plurality of first pad electrodes PAD1 includes a first conductive layer PE1a, a second conductive layer PE1b on the first conductive layer PE1a, and a third conductive layer PE1c on the second conductive layer PE1b.

First, the first conductive layer PE1a is disposed on the second interlayer insulating layer 114. The first conductive layer PE1a may be formed of the same material as the source electrode SE and the drain electrode DE. The first conductive layer PE1a may be configured by a conductive material such as copper (Cu), aluminum (Al), molybdenum (Mo), nickel (Ni), titanium (Ti), chrome (Cr), or an alloy thereof, but is not limited thereto.

The first passivation layer 115a is disposed on the first conductive layer PE1a. The first passivation layer 115a extends from the active area AA to the non-active area NA. Referring to FIG. 6, the first passivation layer 115a is disposed so as to cover an end of the first conductive layer PE1a in an area overlapping the plurality of first pad electrodes PAD1. Referring to FIG. 7, the first passivation layer 115a may be disposed to extend to an area of the non-active area NA which does not overlap the plurality of first pad electrodes PAD1, that is, extend to an outermost side of the top surface of the first substrate 110 between the plurality of first pad electrodes PAD 1. In the meantime, even though it is not illustrated in the drawing, the first passivation layer 115a may be disposed to extend to an outermost side of the top surface of the first substrate 110 also in the left and right non-active areas NA of the first substrate 110, other than the pad area.

The first planarization layer 116a is disposed on the first conductive layer PE1a and the first passivation layer 115a. Referring to FIG. 6, the first planarization layer 116a covers an end of the first passivation layer 115a in an area overlapping the plurality of first pad electrodes PAD1. Therefore, the first planarization layer 116a covers the first passivation layer 115a to suppress the damage to be caused in the first passivation layer 115a which is an inorganic insulating layer during a subsequent process.

In the meantime, the first planarization layer 116a which extends from the active area AA to the plurality of pad areas PA1 and PA2 of the non-active area NA may be disposed to be spaced apart from the plurality of first pad electrodes PAD1 in a peripheral portion of the plurality of first pad electrodes PAD1. For example, the first planarization layer 116a is spaced apart from the first pad electrode PAD1 between the plurality of first pad electrodes PAD1 of the first pad area PA1. Further, the first passivation layer 115a and the second passivation layer 115b are disposed to be in contact with each other in an area in which the plurality of first pad electrodes PAD1 and the first planarization layer 116a are spaced apart from each other. Therefore, the first planarization layer 116a is not in contact with the plurality of first pad electrodes PAD1 in the peripheral portion of the plurality of first pad electrodes PAD1 and the first planarization layer 116a is enclosed by the first passivation layer 115a and the second passivation layer 115b. Therefore, the moisture permeation to the first pad electrode PAD1 due to the first planarization layer 116a which is an organic material may be minimized.

The second conductive layer PE1b is disposed on the first conductive layer PE1a, the first passivation layer 115a, and the first planarization layer 116a. The second conductive layer PE1b may be formed of the same material as the reflection plate RF. The second conductive layer PE1b may be formed of a conductive material and for example, may be configured by silver (Ag), aluminum (Al), molybdenum (Mo), or an alloy thereof, but is not limited thereto.

The second passivation layer 115b is disposed on the second conductive layer PE1b and the first planarization layer 116a. The second passivation layer 115b extends from the active area AA to the non-active area NA to cover the first planarization layer 116a.

Referring to FIG. 6, the second passivation layer 115b is disposed to cover one end of the second conductive layer PE1b in an area overlapping the plurality of first pad electrodes PAD1 and is disposed to be in contact with the first passivation layer 115a.

Referring to FIG. 7, the second passivation layer 115b covers the first planarization layer 116a in an area between the plurality of first pad electrodes PAD1 and an end of the second passivation layer 115b is disposed on the first passivation layer 115a. That is, the first passivation layer 115a and the second passivation layer 115b are disposed to be in contact with each other in an area between the plurality of first pad electrodes PAD1 which does not overlap the plurality of first pad electrodes PAD1.

Even though it is not illustrated in the drawing, the first passivation layer 115a and the second passivation layer 115b may be disposed to be in contact with each other also in left and right non-active areas NA of the first substrate 110. Therefore, the first passivation layer 115a and the second passivation layer 115b may be disposed to have a structure which seals the end of the first planarization layer 116a while being in contact with each other in all the non-active areas NA.

An adhesive layer AD is disposed on the second passivation layer 115b. The adhesive layer AD extends from the pixel area UPA to the non-active area NA. Referring to FIGS. 6 and 7, the end of the adhesive layer AD is disposed at the outside from the end of the first planarization layer 116a in the non-active area NA. Therefore, the adhesive layer AD may alleviate the step by the first planarization layer 116a.

Referring to FIG. 6, in the area overlapping the plurality of first pad electrodes PAD1, the adhesive layer AD is disposed so as to cover an end of the second passivation layer 115b. Referring to FIG. 7, the adhesive layer AD is disposed so as to cover an end of the second passivation layer 115b also in the non-active area NA which is an area between the plurality of first pad electrodes PAD1. Therefore, the adhesive layer AD may buffer the end of the second passivation layer 115b which is an inorganic material by covering the end of the second passivation layer 115b.

The second planarization layer 116b is disposed on the adhesive layer AD. The second planarization layer 116b may be disposed to extend to a part of the non-active area NA from the active area AA or may be disposed only in the active area AA. At this time, the second planarization layer 116b may be disposed to partially have a lower thickness using a halftone mask. Therefore, the second planarization layer 116b may reduce steps of structures laminated in the vicinity of the plurality of first pad electrodes PAD1.

The third conductive layer PE1c is disposed on the second conductive layer PElb, the adhesive layer AD, and the second planarization layer 116b. The third conductive layer PE1c is formed of the same material as the first connection electrode CE1 and the second connection electrode CE2. The third conductive layer PE1c may be formed of a transparent conductive material, such as indium tin oxide (ITO) or indium zinc oxide (IZO), but is not limited thereto.

A bank BB is disposed on the third conductive layer PE1c and the second planarization layer 116b. The bank BB may be disposed to extend to a part of the non-active area NA from the active area AA. The bank BB is disposed to enclose the plurality of light emitting diodes 130 and may be formed of an opaque material including a black material to reduce color mixture between the plurality of sub pixels SP and for example, may be formed of black resin, but is not limited thereto.

A first protection layer 117 is disposed on the third conductive layer PE1c, the second planarization layer 116b, and the bank BB. The first protection layer 117 is disposed to extend to a part of the non-active area NA from the active area AA. Therefore, an end of the first protection layer 117 may be disposed in the non-active area NA.

Referring to FIGS. 6 and 7, an end of the bank BB is disposed in the inside from the end of the first protection layer 117. That is, the first protection layer 117 covers the bank BB to minimize the contamination of the other components of the display device 100 by the bank BB including the black material.

The third passivation layer 115c is disposed on the first protection layer 117. The third passivation layer 115c is disposed in the active area AA and a part of the non-active area NA extending from the active area AA. Referring to FIGS. 6 and 7, the third passivation layer 115c may be disposed so as to cover an end of the first protection layer 117. Therefore, the third passivation layer 115c may be disposed to cover the first protection layer 117 to minimize the moisture permeation of the first protection layer 117.

Referring to FIG. 6, in the area overlapping the plurality of first pad electrodes PAD1, the end of the third passivation layer 115c is disposed to be in contact with the third conductive layer PE1c of the first pad electrode PAD1. Therefore, the third passivation layer 115c may more stably cover the end of the first protection layer 117 disposed on the third conductive layer PE1c.

At this time, even though it is not illustrated in the drawings, a part of the plurality of conductive layers of the first pad electrode PAD1 is electrically connected to a plurality of wiring lines on the first substrate 110 to supply various signals to a plurality of wiring lines and a plurality of sub pixels SP. For example, the first conductive layer and/or the second conductive layer of the first pad electrode PAD1 is connected to the data line DL, the high potential power line VL1, the low potential power line VL2, and the like disposed in the active area AA to transmit signals thereto.

Referring to FIG. 6, the plurality of metal layers and inorganic insulating layers are disposed between the plurality of first pad electrodes PAD1 and the first substrate 110.

The plurality of metal layers includes a first metal layer ML1 and a second metal layer ML2 on the first metal layer ML1. The first metal layer ML1 and the second metal layer ML2 may be disposed together with the plurality of insulating layers below the first pad electrodes PAD1, for example, the buffer layer 111, the gate insulating layer 112, the first interlayer insulating layer 113, and the second interlayer insulating layer 114. Therefore, the plurality of metal layers may be insulated from the plurality of first pad electrodes PAD1. In the meantime, the plurality of metal layers may not be electrically connected to the other components, but may be electrically floated.

In the meantime, referring to FIG. 6, in the area overlapping the plurality of first pad electrodes PAD1, an end of the third passivation layer 115c is disposed at the inside from the end of the inorganic insulating layers. Referring to FIG. 7, between the plurality of first pad electrodes PAD1, an end of the third passivation layer 115c is disposed so as to overlap the ends of the inorganic insulating layers. Further, even though it is not illustrated in the drawing, also in the non-active area at the left side and the right side of the first substrate 110, the end of the third passivation layer 115c may be disposed so as to overlap ends of the inorganic insulating layers, but is not limited thereto.

In the display device 100 according to the exemplary embodiment of the present disclosure, the first metal layer ML1, the second metal layer ML2, and the plurality of insulating layers are disposed below the first pad electrode PAD1 to adjust a step of the first pad electrode PAD1. For example, the buffer layer 111, the gate insulating layer 112, the first metal layer ML1, the first interlayer insulating layer 113, and the second metal layer ML2 may be sequentially disposed between the first pad electrode PAD1 and the first substrate 110.

The first metal layer ML1 may be formed of the same conductive material as the gate electrode GE and the second metal layer ML2 may be formed of the same conductive material as a 1-2-th capacitor electrode C1b. However, the plurality of insulating layers, the first metal layer ML1, and the second metal layer ML2 below the first pad electrode PAD1 may be omitted depending on a design and are not limited thereto.

In the meantime, referring to FIG. 6, an area of the plurality of metal layers on the plane may be smaller than an area of the first pad electrode PAD1 on the plane, but is not limited thereto.

A second substrate 120 is disposed below the first substrate 110. The second substrate 120 is a substrate which supports components disposed below the display device 100 and may be an insulating substrate. For example, the second substrate 120 may be formed of glass, resin, or the like. Further, the second substrate 120 may include polymer or plastic. The second substrate 120 may be formed of the same material as the first substrate 110. In some exemplary embodiments, the second substrate 120 may be formed of a plastic material having flexibility.

A bonding layer BDL is disposed between the first substrate 110 and the second substrate 120. The bonding layer BDL may be formed of a material which is cured by various curing methods to bond the first substrate 110 and the second substrate 120. The bonding layer BDL may be disposed only in a partial area between the first substrate 110 and the second substrate 120 or may be disposed in the entire area therebetween.

A plurality of second pad electrodes PAD2 is disposed on a rear surface of the second substrate 120. The plurality of second pad electrodes PAD2 is electrodes which transmit a signal from a driving component disposed on the rear surface of the second substrate 120 to a plurality of side lines SRL to be described below and a plurality of first pad electrodes PAD1 and a plurality of wiring lines on the first substrate 110. The plurality of second pad electrodes PAD2 is disposed in an end portion of the second substrate 120 in the non-active area NA to be electrically connected to the side line SRL which covers the end portion of the second substrate 120.

At this time, the plurality of second pad electrodes PAD2 may be also disposed so as to correspond to the plurality of pad areas. The plurality of first pad electrodes PAD1 may be disposed to correspond to the plurality of second pad electrodes PAD2, respectively, and then the first pad electrode PAD1 and the second pad electrode PAD2 which overlap each other may be electrically connected through the side line SRL.

Each of the plurality of second pad electrodes PAD2 includes a plurality of conductive layers. For example, each of the plurality of second pad electrodes PAD2 includes a fourth conductive layer PE2a, a fifth conductive layer PE2b, and a sixth conductive layer PE2c.

First, the fourth conductive layer PE2a is disposed below the second substrate 120. The fourth conductive layer PE2a may be configured by a conductive material such as copper (Cu), aluminum (Al), molybdenum (Mo), nickel (Ni), titanium (Ti), chrome (Cr), or an alloy thereof, but is not limited thereto.

The fifth conductive layer PE2b is disposed below the fourth conductive layer PE2a. The fifth conductive layer PE2b may be configured by a conductive material, such as copper (Cu), aluminum (Al), molybdenum (Mo), nickel (Ni), titanium (Ti), chrome (Cr), or an alloy thereof, but is not limited thereto.

The sixth conductive layer PE2c is disposed below the fifth conductive layer PE2b. The sixth conductive layer PE2c may be formed of a conductive material, for example, a transparent conductive material, such as indium tin oxide (ITO) or indium zinc oxide (IZO), but is not limited thereto.

The second protection layer 121 is disposed in the remaining area of the second substrate 120. The second protection layer 121 may protect various wiring lines and driving components formed on the second substrate 120. The second protection layer 121 may be configured by an organic insulating material, and for example, configured by benzocyclobutene or an acrylic organic insulating material, but is not limited thereto.

In the meantime, even though it is not illustrated in the drawing, a driving component including a plurality of flexible films and a printed circuit board may be disposed on a rear surface of the second substrate 120. The plurality of flexible films is components in which various components such as a data driver IC are disposed on a base film having a ductility to supply signals to the plurality of sub pixels SP. The printed circuit board is a component which is electrically connected to the plurality of flexible films to supply signals to the driving IC. On the printed circuit board, various components for supplying various signals to the driving IC may be disposed.

For example, the fourth conductive layer PE2a and/or the fifth conductive layer PE2b of the second pad electrode PAD2 extends to the plurality of flexible films disposed on the rear surface of the second substrate 120 to be electrically connected to the plurality of flexible films. The plurality of flexible films may supply various signals to the plurality of side lines SRL, the plurality of first pad electrodes PAD1, the plurality of wiring lines, and the plurality of sub pixels SP through the second pad electrode PAD2. Therefore, the signal from the driving component may be transmitted to the signal line SL and the plurality of sub pixels SP on the front surface of the first substrate 110 through the plurality of second pad electrodes PAD2 of the second substrate 120, the side line SRL, and the plurality of first pad electrodes PAD1 of the first substrate 110.

Next, the plurality of side lines SRL is disposed on the side surfaces of the first substrate 110 and the second substrate 120. The plurality of side lines SRL may electrically connect the plurality of first pad electrodes PAD1 formed on the top surface of the first substrate 110 and the plurality of second pad electrodes PAD2 formed on the rear surface of the second substrate 120. The plurality of side lines SRL may be disposed so as to enclose the side surface of the display device 100. Each of the plurality of side lines SRL may cover the first pad electrode PAD1 at an end portion of the first substrate 110, a side surface of the first substrate 110, a side surface of the second substrate 120, and the second pad electrode PAD2 at an end portion of the second substrate 120. For example, the plurality of side lines SRL may be formed by a pad printing method using a conductive ink, for example, including silver (Ag), copper (Cu), molybdenum (Mo), chrome (Cr), and the like.

A side insulating layer 140 which covers the plurality of side lines SRL is disposed. The side insulating layer 140 may be formed on the top surface of the first substrate 110, the side surface of the first substrate 110, the side surface of the second substrate 120, and the rear surface of the second substrate 120 to cover the side line SRL. The side insulating layer 140 may protect the plurality of side lines SRL.

At this time, when the plurality of side lines SRL is formed of a metal material, there may be a problem in that external light is reflected from the plurality of side lines SRL or light emitted from the light emitting diode 130 is reflected from the plurality of side lines SRL to be visibly recognized by the user. Therefore, the side insulating layer 140 is configured to include a black material to suppress reflection of the external light. For example, the side insulating layer 140 may be formed by a pad printing method using an insulating material including a black material, for example, a black ink.

A seal member 150 which covers the side insulating layer 140 is disposed. The seal member 150 is disposed so as to enclose the side surface of the display device 100 to protect the display device 100 from external impacts, moisture and oxygen, or the like. For example, the seal member 150 may be formed of polyimide (PI), poly urethane, epoxy, or acryl based insulating material, but is not limited thereto.

In the meantime, referring to FIGS. 5 to 7, an optical film MF which covers upper portions of the seal member 150, the side insulating layer 140, and the third passivation layer 115c may be disposed in the entire upper area of the first substrate 110. The optical film MF may be a functional film which implements a higher quality of images while protecting the display device 100. For example, the optical film MF may include an anti-scattering film, an anti-glare film, an anti-reflecting film, a low-reflecting film, an Oled transmittance controllable film, a polarizer, or the like, but is not limited thereto.

At this time, an adhering unit 118 is disposed between the seal member 150, the side insulating layer 140, and the third passivation layer 115c and the optical film MF. The adhering unit 118 is formed on the front surface of the first substrate 110 to bond between the seal member 150, the side insulating layer 140, and the third passivation layer 115c and the optical film MF. The adhering unit 118 may be formed of a photo curable adhesive material which is cured by light. For example, the adhering unit 118 may be formed of an acrylic material including a photoresist, but is not limited thereto.

In the present disclosure, the adhering unit 118 and the optical film MF are defined as separate components, but the present disclosure is not limited thereto and the optical film MF and the adhering unit 118 may be defined as one component.

In the meantime, an edge of the seal member 150 and an edge of the optical film MF may be disposed on the same line. The optical film MF having a larger size is attached above the first substrate 110 during the manufacturing process of the display device 100 and the seal member 150 which covers the side insulating layer 140 may be formed. Thereafter, laser is irradiated on the seal member 150 and the optical film MF so as to correspond to an edge of the display device 100 to cut a part of the seal member 150 and the optical film MF. Accordingly, the size of the display device 100 is adjusted by an outer periphery cutting process of the seal member 150 and the optical film MF and the edge of the display device 100 may be formed to be flat.

A protection layer for protecting the plurality of light emitting diodes is disposed above the plurality of light emitting diodes. At this time, the protection layer may be formed of an organic material to planarize upper portions of the light emitting diodes. However, when moisture permeates the protection layer which is formed of an organic material, the protection layer expands in a high temperature and high humidity environment to cause a short defect to an electrode which is electrically connected to the light emitting diode. Specifically, the protection layer may be formed to have a relatively smaller thickness in an outermost area of the protection layer which is formed of an organic material. Therefore, the light emitting diode disposed to be adjacent to the outermost periphery of the protection layer may become more vulnerable to the defect caused by the moisture permeation of the protection layer. When the short defect is caused in the electrode which is electrically connected to the light emitting diode due to the moisture permeation to the protection layer as described above, there may be problems in that a dark spot is recognized to a user and a display quality of the display device is degraded.

Therefore, in the display device 100 according to the exemplary embodiment of the present disclosure, the third passivation layer 115c is disposed on the first protection layer 117 to minimize the moisture permeation to the first protection layer 117.

Specifically, in the display device 100 according to the exemplary embodiment of the present disclosure, the third passivation layer 115c is disposed in the active area AA and a part of the non-active area NA extending from the active area AA and is configured to cover an end of the first protection layer 117. Therefore, the third passivation layer 115c covers both the upper portion and the side portion of the first protection layer 117 to minimize the moisture permeation caused above the first protection layer 117. The moisture permeation to the first protection layer 117 may be minimized. Therefore, in the display device 100 according to the exemplary embodiment of the present disclosure, the third passivation layer 115c is disposed on the first protection layer 117 to minimize the moisture permeation to the first protection layer 117.

The display device 100 according to the exemplary embodiment of the present disclosure minimizes the moisture permeation to the first protection layer 117 to minimize the defect of the light emitting diode 130.

Specifically, in the display device 100 according to the exemplary embodiment of the present disclosure, the third passivation layer 115c is disposed to minimize the moisture permeation to the first protection layer 117. Therefore, expansion of the first protection layer 117 which is disposed above the plurality of light emitting diodes 130 due to the moisture permeation in the high temperature and high humidity environment may be minimized. Further, the short defect generated between the electrodes which are electrically connected to the plurality of light emitting diodes 130 may be minimized. Accordingly, the display device 100 according to the exemplary embodiment of the present disclosure minimizes the moisture permeation to the first protection layer 117 to minimize the defect of the light emitting diode 130 and improve the display quality of the display device 100.

The exemplary embodiments of the present disclosure can also be described as follows:

According to an aspect of the present disclosure, a display device includes a substrate including an active area in which a plurality of sub pixels is disposed and a non-active area which encloses the active area; a plurality of transistors disposed in each of the plurality of sub pixels; a first passivation layer which covers the plurality of transistors and is formed of an inorganic material; a first planarization layer which covers the first passivation layer; a second passivation layer which covers the first planarization layer and is formed of an inorganic material; an adhesive layer disposed on the second passivation layer; a plurality of light emitting diodes disposed on the adhesive layer; a first protection layer disposed on the adhesive layer and the plurality of light emitting diodes; and a third passivation layer which covers the first protection layer and is formed of an inorganic material.

An end of the first protection layer may be disposed in the non-active area.

The third passivation layer may be disposed in the active area and a part of the non-active area extending from the active area.

The third passivation layer may cover an end of the first protection layer.

The display device may further comprise a plurality of pad electrodes which is disposed in the non-active area on a top and a bottom of the substrate and transmits a signal to the plurality of sub pixels; and an inorganic insulating layer disposed between the plurality of pad electrodes and the substrate.

An end of the third passivation layer may be disposed so as to overlap an end of the inorganic insulating layer between the plurality of pad electrodes.

The end of the third passivation layer may be disposed inside from the end of the inorganic insulating layer in an area overlapping the plurality of pad electrodes.

The end of the third passivation layer may be in contact with the plurality of pad electrodes in the area overlapping the plurality of pad electrodes.

The end of the third passivation layer may be disposed so as to overlap the end of the inorganic insulating layer in left and right non-active areas of the substrate.

The first passivation layer and the second passivation layer may be disposed to be in contact with each other in an area between the plurality of pad electrodes.

The display device may further comprise a bank which is disposed so as to enclose the plurality of light emitting diodes between the adhesive layer and the first protection layer.

The bank may be formed of a material including a black material.

An end of the bank may be disposed inside from an end of the first protection layer.

The display device may further comprise a second planarization layer disposed between the adhesive layer and the bank in the active area; and a third planarization layer disposed on the second planarization layer.

The second planarization layer may be in contact with a part of a side surface of the light emitting diodes and the third planarization layer may cover a top of the light emitting diodes.

The display device may further comprise an optical film which covers an upper portion of the third passivation layer in an entire upper portion of the substrate; and an adhering unit disposed between the third passivation layer and the optical film.

The active area may further include a plurality of gate driving areas which extends from the plurality of sub pixels and may include a gate driver disposed therein.

Active layers of a plurality of transistors disposed in the plurality of sub pixels and active layers of a plurality of transistors disposed in the gate driver may be formed of oxide semiconductor, amorphous silicon, or polysilicon.

The plurality of transistors disposed in the gate driver may include active layers formed of different materials.

Although the exemplary embodiments of the present disclosure have been described in detail with reference to the accompanying drawings, the present disclosure is not limited thereto and may be embodied in many different forms without departing from the technical concept of the present disclosure. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described exemplary embodiments are illustrative in all aspects and do not limit the present disclosure. The protective scope of the present disclosure should be construed based on the following claims.

## Claims

1. A display device (100), comprising:
a substrate (110) including an active area (AA) in which a plurality of sub pixels (SP) is disposed and a non-active area (NA) which encloses the active area (AA);
a plurality of transistors (DT) disposed in each of the plurality of sub pixels (SP);
a first passivation layer (115a) which covers the plurality of transistors (DT) and is formed of an inorganic material;
a first planarization layer (116a) which covers the first passivation layer (115a);
a second passivation layer (115b) which covers the first planarization layer (116a) and is formed of an inorganic material;
an adhesive layer (AD) disposed on the second passivation layer (115b);
a plurality of light emitting diodes (130) disposed on the adhesive layer (AD);
a first protection layer (117) disposed on the adhesive layer (AD) and the plurality of light emitting diodes (130); and
a third passivation layer (115c) which covers the first protection layer (117) and is formed of an inorganic material.

2. The display device (100) according to claim 1, wherein an end of the first protection layer (117) is disposed in the non-active area (NA).

3. The display device (100) according to claim 2, wherein the third passivation layer (115c) is disposed in the active area (AA) and a part of the non-active area (NA) extending from the active area (AA).

4. The display device (100) according to any of claims 1 to 3, wherein the third passivation layer (115c) covers an end of the first protection layer (117).

5. The display device (100) according to any of claims 1 to 4, further comprising:
a plurality of pad electrodes (PAD1, PAD2) which is disposed in the non-active area (NA) on a top and a bottom of the substrate (110) and transmits a signal to the plurality of sub pixels (SP); and
an inorganic insulating layer disposed between the plurality of pad electrodes (PAD1, PAD2) and the substrate (110),
wherein an end of the third passivation layer (115c) is disposed so as to overlap an end of the inorganic insulating layer between the plurality of pad electrodes (PAD1, PAD2).

6. The display device (100) according to claim 5, wherein the end of the third passivation layer (115c) is disposed inside from the end of the inorganic insulating layer in an area overlapping the plurality of pad electrodes (PAD1, PAD2).

7. The display device (100) according to claim 6, wherein the end of the third passivation layer (115c) is in contact with the plurality of pad electrodes (PAD1, PAD2) in the area overlapping the plurality of pad electrodes (PAD1, PAD2).

8. The display device (100) according to any of claims 5 to 7, wherein the end of the third passivation layer (115c) is disposed so as to overlap the end of the inorganic insulating layer in left and right non-active areas (NA) of the substrate (110).

9. The display device (100) according to any of claims 5 to 8, wherein the first passivation layer (115a) and the second passivation layer (115b) are disposed to be in contact with each other in an area between the plurality of pad electrodes (PAD1, PAD2).

10. The display device (100) according to any of claims 1 to 9, further comprising:
a bank (BB) which is disposed so as to enclose the plurality of light emitting diodes (130) between the adhesive layer (AD) and the first protection layer (117),
wherein the bank (BB) is formed of a material including a black material.

11. The display device (100) according to claim 10, wherein an end of the bank (BB) is disposed inside from an end of the first protection layer (117).

12. The display device (100) according to claim 10 or 11, further comprising:
a second planarization layer (116b) disposed between the adhesive layer (AD) and the bank (BB) in the active area (AA); and
a third planarization layer (116c) disposed on the second planarization layer (116b),
wherein the second planarization layer (116b) is in contact with a part of a side surface of the light emitting diodes (130) and the third planarization layer (116c) covers a top of the light emitting diodes (130).

13. The display device (100) according to any of claims 1 to 12, further comprising:
an optical film (MF) which covers an upper portion of the third passivation layer (115c) in an entire upper portion of the substrate (110); and
an adhering unit (118) disposed between the third passivation layer (115c) and the optical film (MF).

14. The display device (100) according to any of claims 1 to 13, wherein the active area (AA) further includes a plurality of gate driving areas (GA) which extends from the plurality of sub pixels (SP) and includes a gate driver (GD) disposed therein.

15. The display device (100) according to claim 14, wherein active layers of a plurality of transistors (DT) disposed in the plurality of sub pixels (SP) and active layers of a plurality of transistors disposed in the gate driver (GD) are formed of oxide semiconductor, amorphous silicon, or polysilicon,
wherein, preferably, the plurality of transistors disposed in the gate driver (GD) includes active layers formed of different materials.
